# EUROPÄISCHE PATENTANMELDUNG

(11) **EP 4 451 815 A1**
(43) Veröffentlichungstag der Anmeldung: **23.10.2024**
(21) Anmeldenummer: 24167569.3
(22) Anmeldetag: 28.03.2024
(51) Int. Cl.: H05K 5/06, H05K 7/20

(54) **LEITERPLATTEN-BAUGRUPPE**

(30) Priorität: 18.04.2023 DE 202023102004 U
(71) Anmelder: Murrelektronik GmbH, 71570 Oppenweiler (DE)
(72) Erfinder: Feisst, Heiko, 71570 Oppenweiler (DE); Maier, Jan, 71570 Oppenweiler (DE); Roolf, Tim, 71570 Oppenweiler (DE); Ruf, Henrik, 71570 Oppenweiler (DE)
(74) Vertreter: Prinz & Partner mbB

(57) **Zusammenfassung**

Eine Leiterplatten-Baugruppe (10) für ein Feldbusgerät ist beschrieben, mit einem Gehäuse (12), einer Leiterplatte (20) und wenigstens einem elektronischen Bauteil (26), das an der Leiterplatte (20) befestigt ist. Die Leiterplatte (20) ist in dem Gehäuse (12) angeordnet. Das Gehäuse (12) weist wenigstens eine Auflagefläche (30) auf, auf der ein Gap-Filler (28) angeordnet ist, an dem das elektronische Bauteil (26) anliegt, sodass die Leiterplatte (20) über das elektronische Bauteil (26) und den Gap-Filler (28) im Gehäuse (12) gelagert ist. Eine Vergussmasse (32) ist vorgesehen, die die Leiterplatte (20) bedeckt und den Gap-Filler (28) kontaktiert.

## Beschreibung

Die Erfindung betrifft eine Leiterplatten-Baugruppe für ein Feldbusgerät.

Aus dem Stand der Technik sind unter anderem Feldbusgeräte bekannt, die ein Feldbusgehäuse aufweisen, in dem eine Leiterplatte montiert wird. Üblicherweise wird die Leiterplatte über Abstützungen in dem Gehäuse positioniert, wobei anschließend eine Vergussmasse in das Gehäuse eingebracht wird, um die Leiterplatte vollständig zu umschließen. Dabei werden auf der Leiterplatte angeordnete elektronische Bauteile von der Vergussmasse ebenfalls umschlossen, wodurch sichergestellt ist, dass die elektronischen Bauteile nach außen hin geschützt sind, insbesondere vor Feuchtigkeit. Mit anderen Worten sind dann sowohl die Leiterplatte als auch die auf der Leiterplatte angeordneten elektronischen Bauteile in der Vergussmasse eingebettet.

Als nachteilig hat sich hierbei herausgestellt, dass die Wärme über die Vergussmasse abgeleitet werden muss, um eine Überhitzung der elektronischen Bauteile im Betrieb zu vermeiden.

Die Aufgabe der Erfindung ist es, eine Leiterplatten-Baugruppe bereitzustellen, die eine verbesserte Wärmeabfuhr sicherstellt.

Die Aufgabe wird erfindungsgemäß gelöst durch eine Leiterplatten-Baugruppe für ein Feldbusgerät, mit einem Gehäuse, einer Leiterplatte und wenigstens einem elektronischen Bauteil, das an der Leiterplatte befestigt ist. Die Leiterplatte ist in dem Gehäuse angeordnet. Das Gehäuse weist wenigstens eine Auflagefläche auf, auf der ein Gap-Filler angeordnet ist, an dem das elektronische Bauteil anliegt, sodass die Leiterplatte über das elektronische Bauteil und den Gap-Filler im Gehäuse gelagert ist. Eine Vergussmasse ist vorgesehen, die die Leiterplatte bedeckt und den Gap-Filler kontaktiert.

Der Grundgedanke der Erfindung ist es, das elektronische Bauteil über den Gap-Filler direkt mit dem Gehäuse zu koppeln, wodurch eine Wärmeleitung über den Gap-Filler zum Gehäuse hergestellt ist. Der Gap-Filler dient zudem als Anlage für die Vergussmasse, da beim anschließenden Vergussprozess die Vergussmasse nicht vollständig in das Gehäuse eindringen kann, sondern nur bis zum Gap-Filler. Insofern sind mittels des Gap-Fillers zwei Funktionen gleichzeitig verwirklicht, nämlich eine Barriere für die Vergussmasse sowie die thermische Anbindung des wenigstens einen elektronischen Bauteils.

Da die Leiterplatte über das elektronische Bauteil und den Gap-Filler im Gehäuse gelagert ist, ist das elektronische Bauteil zwischen der Leiterplatte und dem Gap-Filler angeordnet. Mit anderen Worten ist der Gap-Filler auf einer Auflagefläche des Gehäuses angeordnet, wobei das elektronische Bauteil, welches an der Leiterplatte angeordnet ist, über den Gap-Filler an das Gehäuse angebunden ist, insbesondere an die Auflagefläche des Gehäuses.

In einer Schnittansicht der Leiterplatten-Baugruppe ergibt sich also ein Gehäuseabschnitt, der die Auflagefläche des Gehäuses umfasst, auf dem der Gap-Filler angeordnet ist, wobei auf den Gap-Filler das elektronische Bauteil angeordnet ist, das mit seiner zum Gap-Filler entgegengesetzten Seite an der Leiterplatte angeordnet ist. Auf der anderen Seite der Leiterplatte, also derjenigen, die vom elektronischen Bauteil abgewandt ist, ist die Vergussmasse angeordnet. Anders ausgedrückt, ist das elektronische Bauteil zwischen dem Gap-Filler und der Leiterplatte angeordnet, wohingegen die Vergussmasse auf der vom Gap-Filler abgewandten Seite der Leiterplatte flächig aufgebracht ist..

Die Vergussmasse bedeckt demnach das elektronische Bauteil nicht vollständig. Dies liegt daran, dass das elektronische Bauteil an der Seite der Leiterplatte angeordnet ist, die von der Vergussmasse wegweist.

Gap-Filler sind grundsätzlich bekannt. Typischerweise werden Gap-Filler dazu verwendet, Lücken aufzufüllen, wie dies der Name schon sagt. Mit dem Gap-Filler lassen sich vollständig und dauerhaft Spalte füllen, die durch Toleranzen, Bauhöhenunterschiede oder unterschiedliche Ausdehnungskoeffizienten der verwendeten Werkstoffe entstehen. Vorliegend wird der Gap-Filler gezielt als Anbindungsmaterial verwendet, um das elektronische Bauteil und somit die Leiterplatte im Gehäuse zu lagern, thermisch anzubinden und eine Barriere für die Vergussmasse auszubilden. Typischerweise ist der Gap-Filler daher elektrisch nicht leitfähig.

Da der Gap-Filler als Barriere für die Vergussmasse dient bzw. die Vergussmasse den Gap-Filler kontaktiert, entsteht ein Hohlraum. Hierdurch ist gewährleistet, dass keine große Menge an Vergussmasse benötigt wird, wodurch die Leiterplatten-Baugruppe leichter ausgebildet werden kann im Vergleich zu Leiterplatten-Baugruppen, bei denen das gesamte Gehäuse mit der Vergussmasse aufgefüllt ist. Dies ist insbesondere bei bewegten Teilen von Vorteil, beispielsweise einem Roboterkopf, da eine geringere Masse beschleunigt werden muss.

Darüber hinaus ergeben sich hierdurch auch Vorteile bzgl. des Recyclings der Leiterplatten-Baugruppe sowie Kostenvorteile bei der Herstellung, da weniger Vergussmasse verwendet wird.

Der Gap-Filler kann als eine Paste oder als ein vorgefertigtes Pad auf die Auflagefläche aufgebracht worden sein.

Ein Aspekt sieht vor, dass das elektronische Bauteil mittels des Gap-Fillers an der Auflagefläche befestigt ist. Hierdurch ist ferner sichergestellt, dass die Leiterplatte positionsgetreu im Gehäuse angeordnet ist. Ein Verrutschen oder Verschieben der Leiterplatte in dem Gehäuse kann somit verhindert werden. Der Gap-Filler stellt also sicher, dass das elektronische Bauteil fest am Gehäuse befestigt ist.

Insbesondere ist der Gap-Filler klebend, sodass die Leiterplatte über das elektronische Bauteil mittels des Gap-Fillers auf die Auflagefläche aufgeklebt ist. Die mechanische Anbindung der Leiterplatte an das Gehäuse erfolgt somit über den klebenden Gap-Filler, über den das an der Leiterplatte befestigte elektronische Bauteil mit dem Gehäuse verbunden ist, insbesondere mit der Auflagefläche des Gehäuses.

Der Gap-Filler kann also auf die Auflagefläche aufgebracht werden, wobei gleichzeitig die mechanische Anbindung erfolgt, da der Gap-Filler selbst bereits klebend ist. Dies gilt in analoger Weise für die Anbindung des elektronischen Bauteils, was ebenfalls auf den klebenden Gap-Filler gesetzt wird, wodurch das elektronische Bauteil fixiert ist.

Es ist ebenso im Sinne der Erfindung, wenn zum Gap-Filler zusätzliche Anbindungen am Gehäuse vorgesehen sind, beispielsweise Schnappharken oder Schrauben oder ähnliches.

Ein weiterer Aspekt sieht vor, dass der Gap-Filler thermisch leitend ist und das elektronische Bauteil thermisch leitend mit dem Gehäuse verbindet. Es liegt also ein definierter Kühlpfad vor, welcher unter anderem über die Eigenschaften des Gap-Fillers sichergestellt ist, der eine hohe thermische Leitfähigkeit aufweist. Die vom elektronischen Bauteil abgegebene thermische Energie kann hierdurch mit einem geringeren Temperaturunterscheid an das Gehäuse abgeleitet werden, von wo aus die Wärme an die Umgebung abgegeben wird. Die entstehende thermische Verlustleistung wird aufgrund der thermischen Leitfähigkeit des Gap-Fillers, insbesondere im Vergleich zu den thermischen Leitfähigkeiten der weiteren Komponenten, gezielt über den Gap-Filler zum Gehäuse geleitet, von wo aus die thermische Verlustleistung abgegeben werden kann, sodass eine Kühlung des elektronischen Bauteils erfolgt. Eine Überhitzung im Gehäuse kann wirkungsvoll verhindert werden.

Grundsätzlich stellt der Gap-Filler somit sicher, dass eine thermische leitfähige Vergussmasse nicht verwendet werden muss, um die Wärme abzuleiten, also eine speziell veränderte Vergussmasse, die über Zusätze eine höhere thermische Leitfähigkeit hat. Hierdurch lassen sich entsprechend Kosten einsparen.

Ein weiterer Aspekt sieht vor, dass der Gap-Filler elastisch ist, sodass der Gap-Filler als mechanischer Dämpfer fungiert. Der Gap-Filler kann aufgrund seiner Eigenelastizität im Betrieb auftretende Vibrationen und/oder Erschütterungen teilweise dämpfen, sodass diese nur gedämpft an die Leiterplatte und das elektronische Bauteil weitergeleitet werden, wodurch sowohl die Leiterplatte als auch das darauf befestigte elektronische Bauteil vor Erschütterungen bzw. Vibrationen besser geschützt sind.

Beispielsweise ist der Gap-Filler aus einem Elastomer gebildet. Hierzu kann ein Silikon-Elastomer verwendet werden. Grundsätzlich ist über das Elastomer sichergestellt, dass der Gap-Filler die elastischen Eigenschaften hat und somit als Dämpfer wirken kann.

Alternativ kann vorgesehen sein, dass der Gap-Filler aus einem duroplastischen Werkstoff gebildet ist, insbesondere aus einem Polyurethan oder einem Epoxid. Der duroplastische Werkstoff eignet sich insbesondere für Anwendungen, bei denen sichergestellt ist, dass im laufenden Betrieb keine Erschütterungen und/oder Vibrationen auftreten, sodass der Gap-Filler nicht als mechanischer Dämpfer fungieren muss.

Ungeachtet des konkreten Werkstoffs kann vorgesehen sein, dass der Gap-Filler mit einem thermisch leitfähigen Zusatz versehen ist. Der thermisch leitfähige Zusatz stellt sicher, dass der Gap-Filler die gewünschten thermischen Eigenschaften aufweist, um die von dem elektronischen Bauteil erzeugte Wärme abzutransportieren. Insbesondere kann über den thermisch leitfähigen Zusatz die thermische Leitfähigkeit des Gap-Fillers gezielt eingestellt werden.

Beispielsweise ist der thermisch leitfähige Zusatz ein Keramikpulver, insbesondere Aluminiumoxid, Zinkoxid oder Bornitrid, oder ein mineralischer Werkstoff, insbesondere Quarzsand oder Quarzmehl.

Da der Gap-Filler nur zur Anbindung des elektronischen Bauteils genutzt wird, aber nicht zum Einbetten der gesamten Leiterplatte, können die Kosten trotz der Verwendung des thermisch leitfähigen Zusatzes gering(er) gehalten werden, da nur ein verhältnismäßig kleines Volumen mit dem thermisch leitfähigen Zusatz versehen wird.

Insbesondere bedeckt die Vergussmasse eine obere Seite der Leiterplatte vollständig, die zu einer unteren Seite der Leiterplatte entgegengesetzt ist, an der das elektronische Bauteil befestigt ist. Die Vergussmasse umschließt demnach nicht das elektronische Bauteil vollständig. Insofern kann grundsätzlich weniger Vergussmasse vorgesehen sein, wodurch sich entsprechend die Kosten für die Herstellung der Leiterplatten-Baugruppe reduzieren lassen.

Gemäß einem Aspekt dichtet die Vergussmasse das elektronische Bauteil nach außen hin ab. Die Vergussmasse schließt demnach bis an den Gap-Filler an.

Grundsätzlich kann das Gehäuse topfförmig ausgebildet sein und einen Gehäuseboden sowie Seitenwände aufweisen. Mit anderen Worten hat das Gehäuse eine offene Seite, über die die Leiterplatte in das Gehäuse eingebracht werden kann. Bei der Herstellung der Leiterplatten-Baugruppe kann zunächst der Gap-Filler auf die Auflagefläche aufgebracht worden sein, sodass anschließend die Leiterplatte über das elektronische Bauteil auf den Gap-Filler aufgesetzt wird. Sofern der Gap-Filler klebend ausgebildet ist, wird hierdurch die Leiterplatte bereits am Gehäuse fixiert. Abschließend kann die Vergussmasse auf die Leiterplatte aufgebracht werden, wobei die Vergussmasse die Oberseite der Leiterplatte, die zur offenen Seite des topfförmigen Gehäuses weist, bedeckt. Die Vergussmasse kann dabei seitlich an der Leiterplatte herunterlaufen, um zusätzlich die Seite der Leiterplatte sowie den Gap-Filler teilweise zu bedecken, wodurch ein Raum nach außen abgedichtet ist, in dem sich das elektronische Bauteil zumindest teilweise befindet.

Das topfförmige Gehäuse weist beispielsweise fünf Wände auf, nämlich den Gehäuseboden sowie vier Seitenwände.

Die Auflagefläche kann parallel zum Gehäuseboden sein. Die Auflagefläche kann am Gehäuseboden oder separat zum Gehäuseboden vorgesehen sein, wobei eine einfache Ausgestaltung derart ist, dass die Auflagefläche parallel zum Gehäuseboden ist. Dies bietet sich insbesondere dann an, wenn es sich bei dem Gehäuse um ein topfförmiges Gehäuse handelt, das eine offene Seite hat, über die die Leiterplatte eingebracht wird. Die offene Seite des topfförmigen Gehäuses ist typischerweise zum Gehäuseboden entgegengesetzt.

Das Gehäuse kann einen Schulterabschnitt aufweisen, der in einem Übergangsbereich vom Gehäuseboden zu wenigstens einer der Seitenwände vorgesehen ist, wobei an dem Schulterabschnitt die Auflagefläche ausgebildet ist. Aufgrund des Schulterabschnitts ist sichergestellt, dass die Leiterplatte zum Gehäuseboden beabstandet ist, wodurch sich ein entsprechend großer Raum zwischen der Leiterplatte und dem Gehäuseboden ausbilden kann, der zur Aufnahme von elektronischen Bauteilen geeignet ist.

Sofern die Vergussmasse und der Gap-Filler vorgesehen sind, lässt sich dieser Raum entsprechend einfach nach außen hin abdichten, sodass feuchtigkeitssensible Bauteile in dem Raum angeordnet werden können, insbesondere von der Leiterplatte in den Raum hinein abstehen können.

Die Leiterplatte kann beabstandet zu den Seitenwänden im Gehäuse gelagert sein. Hierdurch ist sichergestellt, dass ein Spalt zwischen der Leiterplatte und dem Gehäuse vorliegt, insbesondere den Seitenwänden des Gehäuses. Dieser Spalt kann von der Vergussmasse geschlossen werden, die sich von der Oberseite der Leiterplatte entlang der Seitenwände in Richtung des Gap-Fillers erstreckt.

Der Gap-Filler kann eine höhere thermische Leitfähigkeit als die Vergussmasse haben, sodass eine gezielte Wärmeleitung über den Gap-Filler erfolgt.

Grundsätzlich ist also vorgesehen, dass das Gehäuse nicht vollständig mit einer Vergussmasse gefüllt ist, da der Hohlraum zwischen dem Gehäuseboden und der Leiterplatte ausgebildet ist. Die auf der Oberseite der Leiterplatte vorgesehene Vergussmasse erstreckt sich teilweise entlang der Seitenwände des Gehäuses, insbesondere bis zum Gap-Filler, der zusammen mit der Vergussmasse die Abdichtung ausbildet.

Das Gehäuse kann Anschlussöffnungen aufweisen, über die elektronische Bauteile auf der Leiterplatte oder andere Komponenten angeschlossen werden können. Dies erfolgt vorzugsweise, bevor die Vergussmasse in das Gehäuse eingebracht worden ist.

Auch kann das Gehäuse wenigstens eine Öffnung für eine Flüssigkeitskühlung aufweisen, vorzugsweise zwei Öffnungen.

Das Gehäuse kann an der der Außenseite Strukturen aufweisen, die eine Abgabe von thermischer Energie begünstigen. Hierzu gehören insbesondere Formen, die die Oberfläche vergrößern, beispielsweise Rippen.

Weitere Vorteile und Eigenschaften der Erfindung ergeben sich aus der nachfolgenden Beschreibung und der Figur, auf die Bezug genommen wird. In der Figur ist eine schematische Schnittansicht der erfindungsgemäßen Leiterplatten-Baugruppe gezeigt.

Es ist eine Leiterplatten-Baugruppe 10 gezeigt, die in einem Feldbusgerät verwendet werden kann.

Die Leiterplatten-Baugruppe 10 umfasst ein topfförmiges Gehäuse 12, das einen Gehäuseboden 14 sowie Seitenwände 16 aufweist, also beispielsweise vier Seitenwände 16. Insofern hat das topfförmige Gehäuse 12 eine offene Seite, die zum Gehäuseboden 14 entgegengesetzt ist.

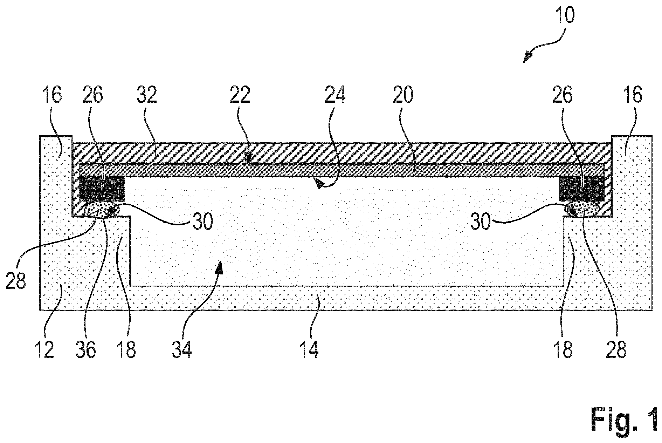

In der gezeigten Ausführungsform hat das Gehäuse 12 einen Schulterabschnitt 18, der in einem Übergangsbereich vom Gehäuseboden 14 zu den Seitenwänden 16 vorgesehen ist. Insofern ergibt sich im Querschnitt des Gehäuses 12 eine stufenförmige Seite, wie aus Figur 1 hervorgeht.

Darüber hinaus umfasst die Leiterplatten-Baugruppe 10 eine Leiterplatte 20, die eine Oberseite 22 und eine Unterseite 24 aufweist, welche entgegengesetzt zueinander sind. Die Unterseite 24 der Leiterplatte 20 weist demnach in Richtung des Gehäusebodens 14, wohingegen die Oberseite 22 der Leiterplatte 20 zur offenen Seite des topfförmigen Gehäuses 12 gewandt ist.

Die Leiterplatten-Baugruppe 10 umfasst zudem wenigstens ein elektronisches Bauteil 26, welches an der Leiterplatte 20 angebracht ist, insbesondere an der Unterseite 24.

Die Leiterplatte 20 ist zudem an dem Gehäuse 12 gelagert, indem die Leiterplatte 20 über das elektronische Bauteil 26 und einen Gap-Filler 28 auf einer Auflagefläche 30 des Gehäuses 12 gelagert ist.

Der Gap-Filler 28 kann klebend sein, sodass die Leiterplatte 20 über das elektronische Bauteil 26 mittels des Gap-Fillers 28 auf der Auflagefläche 30 aufgeklebt ist. Hierdurch ergibt sich die mechanische Fixierung der Leiterplatte 20 im Gehäuse 12.

In der gezeigten Ausführungsform ist die Auflagefläche 30 an dem Schulterabschnitt 18 ausgebildet, wobei die Auflagefläche 30 parallel zum Gehäuseboden 14 verläuft.

Grundsätzlich kann der Gap-Filler 28 elastisch sein, beispielsweise aus einem Elastomer ausgebildet sein, wodurch der Gap-Filler 28 gleichzeitig als mechanischer Dämpfer fungiert, sodass die Leiterplatte 20 und das daran befestigte elektronische Bauteil 26 vor Erschütterung und/oder Vibrationen geschützt ist.

Sofern es nicht notwendig ist, dass der Gap-Filler 28 gleichzeitig als mechanischer Dämpfer fungiert, kann der Gap-Filler 28 auch aus einem duroplastischen Werkstoff gebildet sein. Die kann der Fall sein, wenn die Leiterplatten-Baugruppe 10 in einem Gerät verwendet wird, das im laufenden Betrieb typischerweise weder Erschütterungen noch Vibrationen ausgesetzt ist.

Ferner ist in der Figur gezeigt, dass die Leiterplatten-Baugruppe 10 eine Vergussmasse 32 aufweist, welche unter anderem die Oberseite 22 der Leiterplatte 20 bedeckt, insbesondere vollständig bedeckt. Die Vergussmasse 32 kann dabei eine Dicke aufweisen, sodass sich eine ebene Oberfläche ausbildet, also die Vergussmasse 32 bis zum Rand des Gehäuses 12 ragt. Alternativ können die Seitenwände 16 über die Oberseite der Vergussmasse 32 hinausragen, wodurch ein Absatz gebildet ist, wie dies in der Figur gezeigt ist.

Die Leiterplatte 20 ist insbesondere zu den Seitenwänden 16 des Gehäuses 12 beabstandet, sodass eine Lücke zwischen der Leiterplatte 20 und den Seitenwänden 16 gegeben ist, die von der Vergussmasse 32 aufgefüllt werden kann. Die Vergussmasse 32 erstreckt sich demnach entlang des Spalts zwischen den Seiten der Leiterplatte 20 und den Seitenwänden 16 in Richtung des Gehäusebodens 14 bis zum Gap-Filler 28. Die Vergussmasse 32 schließt also an den Gap-Filler 28 an, sodass dieser von der Vergussmasse 32 kontaktiert ist.

Die Vergussmasse 32 dichtet einen Raum 34 vollständig nach außen hin ab, der zumindest teilweise das elektronische Bauteil 26 aufnimmt. Dieser Raum 34 kann auch als Hohlraum oder als Aufnahmeraum bezeichnet werden. Grundsätzlich können in dem Raum 34 weitere (hier nicht dargestellte) elektronische Bauteile angeordnet sein.

Der Raum 34 ist von der Leiterplatte 20, insbesondere deren Unterseite 24, dem Gehäuseboden 14, der Seitenwände 16, dem elektronischen Bauteil 26 und dem Gap-Filler 28 begrenzt.

Hierdurch ist sichergestellt, dass der Raum 34, in dem das elektronische Bauteil 26 teilweise aufgenommen ist, insbesondere über eine Seite, nach außen hin abgedichtet ist. Grundsätzlich ist das elektronische Bauteil 26 nach außen hin abgedichtet, da das elektronische Bauteil 26 teilweise in den abgedichteten Raum 34 ragt und teilweise vom Gap-Filler 28 sowie der Vergussmasse 32 begrenzt ist.

Da es sich bei dem Raum 34 um einen Hohlraum handelt, ist die Masse der gesamten Leiterplatten-Baugruppe 10 entsprechend gering, was sich positiv auf Anwendungsfälle auswirkt, bei denen die Leiterplatten-Baugruppe 10 an einem Bauteil angeordnet ist, beispielsweise einem Roboterteil.

Der Gap-Filler 28 kann zudem thermisch leitend sein, beispielsweise über einen thermisch leitfähigen Zusatz 36 wie ein Keramikpulver, insbesondere Aluminiumoxid, Zinkoxid oder Bornitrid, beziehungsweise einen mineralischen Werkstoff, insbesondere Quarzsand oder Quarzmehl. Bei dem thermisch leitfähigen Zusatz 36 kann es sich um Partikel handeln.

Hierdurch ist gewährleistet, dass der Gap-Filler 28 eine thermische Anbindung des elektronischen Bauteils 26 an das Gehäuse 12 herstellt, wodurch vom elektronischen Bauteil 26 erzeugte Wärme während des Betriebs über den Gap-Filler 28 an das Gehäuse 12 weitergeleitet wird. Vom Gehäuse 12 kann die Wärme entsprechend an die Umgebung abgegeben werden.

Der Gap-Filler 28 hat demnach zumindest zwei Funktionen, da der Gap-Filler 28 zur gezielten thermischen Anbindung des elektronischen Bauteils 26 an das Gehäuse 12 dient und gleichzeitig das elektronische Bauteil 26 nach außen hin abdichtet.

## Patentansprüche

1. Leiterplatten-Baugruppe (10) für ein Feldbusgerät, mit einem Gehäuse (12), einer Leiterplatte (20) und wenigstens einem elektronischen Bauteil (26), das an der Leiterplatte (20) befestigt ist, wobei die Leiterplatte (20) in dem Gehäuse (12) angeordnet ist, und wobei das Gehäuse (12) wenigstens eine Auflagefläche (30) aufweist, auf der ein Gap-Filler (28) angeordnet ist, an dem das elektronische Bauteil (26) anliegt, sodass die Leiterplatte (20) über das elektronische Bauteil (26) und den Gap-Filler (28) im Gehäuse (12) gelagert ist, wobei eine Vergussmasse (32) vorgesehen ist, die die Leiterplatte (20) bedeckt und den Gap-Filler (28) kontaktiert.

2. Leiterplatten-Baugruppe (10) nach Anspruch 1, **dadurch gekennzeichnet, dass** das elektronische Bauteil (26) mittels des Gap-Fillers (28) an der Auflagefläche (30) befestigt ist.

3. Leiterplatten-Baugruppe (10) nach Anspruch 1 oder 2, **dadurch gekennzeichnet, dass** der Gap-Filler (28) klebend ist, sodass die Leiterplatte (20) über das elektronische Bauteil (26) mittels des Gap-Fillers (28) auf der Auflagefläche (30) aufgeklebt ist.

4. Leiterplatten-Baugruppe (10) nach einem der vorhergehenden Ansprüche, **dadurch gekennzeichnet, dass** der Gap-Filler (28) thermisch leitend ist und das elektronische Bauteil (26) thermisch leitend mit dem Gehäuse (12) verbindet.

5. Leiterplatten-Baugruppe (10) nach einem der vorhergehenden Ansprüche, **dadurch gekennzeichnet, dass** der Gap-Filler (28) elastisch ist, sodass der Gap-Filler (28) als mechanischer Dämpfer fungiert.

6. Leiterplatten-Baugruppe (10) nach einem der vorhergehenden Ansprüche, **dadurch gekennzeichnet, dass** der Gap-Filler (28) aus einem Elastomer gebildet ist.

7. Leiterplatten-Baugruppe (10) nach einem der Ansprüche 1 bis 4, **dadurch gekennzeichnet, dass** der Gap-Filler (28) aus einem duroplastischen Werkstoff gebildet ist, insbesondere aus einem Polyurethan oder einem Epoxid.

8. Leiterplatten-Baugruppe (10) nach einem der vorhergehenden Ansprüche, **dadurch gekennzeichnet, dass** der Gap-Filler (28) mit einem thermisch leitfähigen Zusatz versehen ist.

9. Leiterplatten-Baugruppe (10) nach Anspruch 8, **dadurch gekennzeichnet, dass** der thermisch leitfähige Zusatz (36) ein Keramikpulver, insbesondere Aluminiumoxid, Zinkoxid oder Bornitrid, oder ein mineralischer Werkstoff ist, insbesondere Quarzsand oder Quarzmehl.

10. Leiterplatten-Baugruppe (10) nach einem der vorhergehenden Ansprüche, **dadurch gekennzeichnet, dass** die Vergussmasse (32) eine Oberseite (22) der Leiterplatte (20) vollständig bedeckt, die zu einer Unterseite (24) der Leiterplatte (20) entgegengesetzt ist, an der das elektronische Bauteil (26) befestigt ist.

11. Leiterplatten-Baugruppe (10) nach einem der vorhergehenden Ansprüche, **dadurch gekennzeichnet, dass** die Vergussmasse (32) das elektronische Bauteil (26) nach außen hin abdichten.

12. Leiterplatten-Baugruppe (10) nach einem der vorhergehenden Ansprüche, **dadurch gekennzeichnet, dass** das Gehäuse (12) topfförmig ausgebildet ist und einen Gehäuseboden (14) sowie Seitenwände (16) hat.

13. Leiterplatten-Baugruppe (10) nach Anspruch 12, **dadurch gekennzeichnet, dass** die Auflagefläche (30) parallel zum Gehäuseboden (14) ist.

14. Leiterplatten-Baugruppe (10) nach Anspruch 12 oder 13, **dadurch gekennzeichnet, dass** das Gehäuse (12) einen Schulterabschnitt (18) aufweist, der in einem Übergangsbereich vom Gehäuseboden (14) zu wenigstens einer der Seitenwände (16) vorgesehen ist, wobei an dem Schulterabschnitt (18) die Auflagefläche (30) ausgebildet ist.

15. Leiterplatten-Baugruppe (10) nach einem der vorhergehenden Ansprüche, **dadurch gekennzeichnet, dass** die Leiterplatte (20) beabstandet zu den Seitenwänden (16) im Gehäuse (12) gelagert ist.
